# EUROPEAN PATENT APPLICATION

(11) **EP 1 912 110 A1**
(43) Date of publication of application: **16.04.2008**
(21) Application number: 06255286.4
(22) Date of filing: 13.10.2006
(51) Int. Cl.: G06F 1/20, H05K 7/20

(54) **Electronic device**

(71) Applicant: ASUSTeK Computer Inc., Peitou, Taipei City (TW)
(72) Inventor: Wu, Chun-Chieh, Peitou, Taipei City (TW); Chu, Hung-Chun, Peitou, Taipei City (TW); Lin, Hsi-Feng, Peitou, Taipei City (TW)
(74) Representative: Tranter, Andrew David

(57) **Abstract**

An electronic device has a first circuit board, a first fan, a second circuit board, a first heat sink, and a first air ventilation duct. The first fan and the first circuit board are electrically connected together. The second circuit board is electrically connected to the first circuit board; the first heat sink is electrically connected to the second circuit board; and the first air ventilation duct is connected to the first fan and the first heat sink. The first heat sink introduce the heat generated by the electronic element on the second circuit board to the first fan for better cooling performance. Therefore, the present invention requires only the first fan and the second fan, but is able to provide high cooling efficiencies with a low noise signature.

## Description

### BACKGROUND OF THE INVENTION

### 1. Field of the Invention

The present invention relates to an electronic device, and more particularly, to an electronic device with an air ventilation function which can direct heat to the fan vent.

### 2. Description of Related Art

Modem computer parts, such as CPUs, memory, display cards, etc have increasingly fast processing abilities. For display cards, display cards with higher speeds require more processing chips, and more processing chips means the generation of more heat during operation; therefore, if the cooling is not sufficient, the display card may be damaged by the heat.

Some prior art display cards that generate a great deal of heat come with an attached heat sink made of copper or aluminum. The heat from the card is transfer to the heat sink, which has a larger area, and the heat sink is air cooled. The cooling efficiency of this heat sink depends on the area of the heat sink and the speed of the air flow. However, the display cards are usually disposed on the motherboard with other interface cards, such as audio cards, network cards, and hard disk controllers, which impede the air flow. Moreover, as there is very limited space in the computer case, the area of the heat sink cannot be increased by too much. Therefore, the prior art heat sink is unable to provide adequate cooling.

Some prior art display cards utilize a forced-cooling method, which has both a heat sink and a fan for cooling, which provides a better cooling performance, but is also a source of noise.

Therefore, it is desirable to provide an electronic device with an air ventilation function to mitigate and/or obviate the aforementioned problems.

### SUMMARY OF THE INVENTION

An electronic device comprises a first circuit board, a first fan, a second circuit board, a first heat sink, and a first air ventilation duct. The first fan and the first circuit board are electrically connected together. The second circuit board is electrically connected to the first circuit board. The first heat sink is electrically connected to the second circuit board, and the first air ventilation duct is connected to the first fan and the first heat sink.

The first heat sink induce the heat generated by the electronic element on the second circuit board to the first fan for better cooling performance. Therefore, the present invention requires only the first fan and the second fan, but is able to provide high cooling efficiencies with a low noise signature.

The first air ventilation duct comprises a first vent, a second vent, and a duct body. The duct body connected to the first vent and the second vent. The second vent connected to the first fan, and the first vent connected to the first heat sink. Furthermore, at least one part of the first heat sink is disposed in the first vent. Therefore, the heat generated by the second circuit board is conducted to the first vent of the first fan.

Furthermore, the present invention further comprises a first heat pipe, and a second heat sink. One end of the first heat pipe is fixed on the first heat sink, and another end is fixed on the second heat sink. The second heat sink increases the entire cooling surface area to increase the cooling capabilities.

One side of the first heat sink has a first connection, and the duct body of the first air ventilation duct has a second connection corresponding to the first connection. The first connection is a rounded post or other equivalent design, and the second connection is a through hole or other equivalent design. So the first heat sink can be fixed onto the first air ventilation duct.

The second heat sink comprises a base and a plurality of cooling fins. The plurality of cooling fins are arranged in parallel and connected to the base and used for increasing the entire cooling surface area to increase the cooling capabilities.

The present invention further comprises an electronic element. The electronic element is disposed on the second circuit board. The base is disposed on the second circuit board and contacts to the electronic element. The heat generated by the electronic element is conducted by the base to the second heat sink.

Moreover, the second circuit board can be a display card, or other interface card, and the first fan can be a CPU fan or a system fan.

Other objects, advantages, and novel features of the invention will become more apparent from the following detailed description when taken in conjunction with the accompanying drawings.

### BRIEF DESCRIPTION OF THE DRAWINGS

FIG. 1 is an exploded view of a preferred embodiment of the present invention.
FIG. 2 is a perspective view of the preferred embodiment of the present invention.
FIG. 3 is a schematic drawing of air ventilation cooling according to the preferred embodiment of the present invention.
FIG. 4 is another schematic drawing of air ventilation cooling according to the preferred embodiment of the present invention.

### DETAILED DESCRIPTION OF THE PREFERRED EMBODIMENT

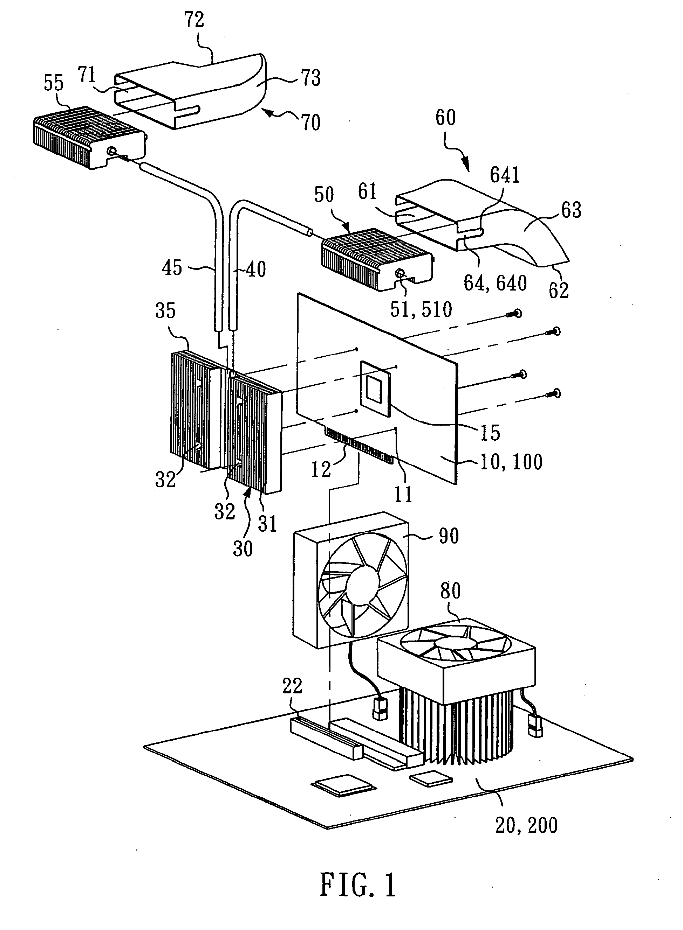

Please refer to FIG. 1. FIG. 1 is an exploded view of a preferred embodiment of the present invention. The embodiment comprises a first circuit board **20,** a second circuit board **10,** an electronic element **15,** a first heat pipe **40,** a second heat pipe **45,** a first heat sink **50,** a second heat sink **30,** a third heat sink **55,** a first air ventilation duct **60,** a second air ventilation duct **70,** a first fan **80,** and a second fan **90.**

As shown in FIG. 1, the first fan **80** is electrically connected to the first circuit board **20,** and the second circuit board **10** is inserted in a socket **22** on the first circuit board **20** via so-called golden fingers **12** and connected to the first circuit board **20.** The second heat sink **30** has a base **35,** four through holes **32,** and a plurality of cooling fins **31;** the plurality of cooling fins **31** are disposed in parallel and connected onto the base **35.** The electronic element **15** is disposed on the second circuit board **10,** and the second heat sink **30** utilizes those four through holes **32** and four corresponding through holes **11 on** the second circuit board **10** to fix the base **35** onto the second circuit board **10;** the base **35** contacts the electronic element **15** to conduct the heat generated by the electronic element **15** through the base **35** to the plurality of cooling fins **31** of the second heat sink **30.** The plurality of cooling fins **31** are used to increase the entire cooling surface area of the second heat sink **30** to increase the cooling capabilities.

In this embodiment, the first circuit board **20** is a motherboard **200** of a computer host, the second circuit board **10** is a display card **100,** and the electronic element **15** is a graphics chip.

As shown in FIG. 1, one end of the first heat pipe **40** is fixed onto the base **35** of the second heat sink **30,** and another end of the first heat pipe **40** is fixed onto the first heat sink **50.** The first air ventilation duct **60** comprises a first vent **61,** a second vent **62,** and a duct body **63.** The duct body **63** is connected to the first vent **61** and the second vent **62;** the second vent **62** is connected to the first fan **80,** and the first vent **61** is connected to the first heat sink **50.** In this embodiment, the first heat sink **50** are all disposed in the first vent **61,** in order to introduce the heat generated by the electronic element **15** on the second circuit board **10** to the first fan **80** for better cooling performance.

The first heat sink **50** has a first connection **51** on its side, and the duct body **63** has a second connection **64** corresponding to the first connection **51,** so the first heat sink **50** can be fixed onto the first air ventilation duct **60.** In this embodiment, the first connection **51** of the first heat sink **50** is a post **510,** and the second connection **64** of the duct body **63** is a slit **640** with a rounded edge **641** which can hook with the post **510** of the first heat sink **50.**

As shown in FIG. 1, one end of the second heat pipe **45** is fixed onto the base **35** of the second heat sink **30,** and another end of the second heat pipe **45** is fixed onto the third heat sink **55.** The second air ventilation duct **70** also comprises a first vent **71,** a second vent **72,** and a duct body **73.** The duct body **73** is connected to the first vent **71** and the second vent **72,** and the second vent **72** is connected to the second fan **90.** The second fan **90** is also electrically connected to the first circuit board **20,** and the first vent **71** is connected to the third heat sink **55.** In this embodiment, the third heat sink **55** is also disposed in the first vent **71** of the second air ventilation duct **70.** The third heat sink **55** is used to increase the entire cooling surface area to increase the cooling performance. The assembly method for the third heat sink **55** and the second air ventilation duct **70** is identical to the connection between the first heat sink **50** and the first air ventilation duct **60.**

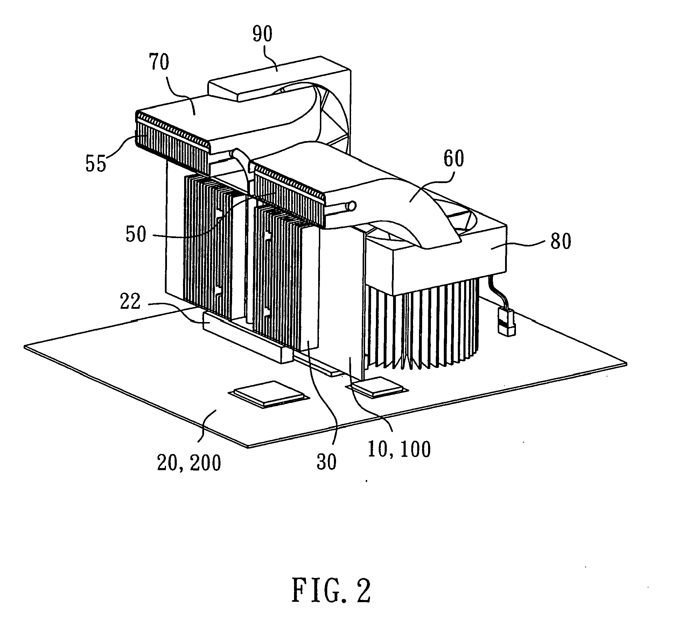

Please refer to FIG. 2. FIG. 2 is a perspective view of the preferred embodiment of the present invention. In this embodiment, the first fan **80** is a CPU fan, and the second fan **90** is a fan for the host system.

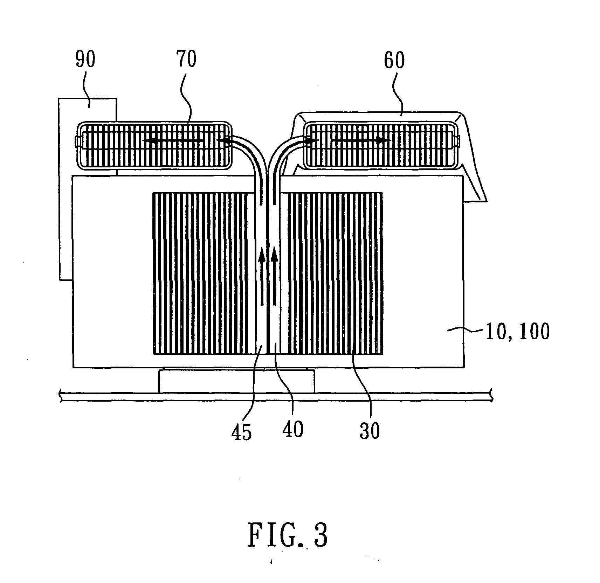

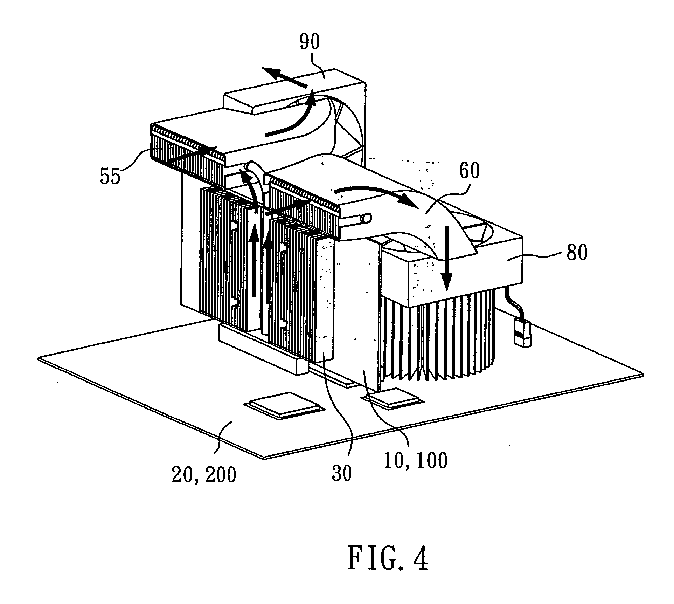

Please refer to FIG. 3 and FIG. 4. FIG. 3 is a schematic drawing of air ventilation cooling according to the preferred embodiment of the present invention. FIG. 4 is another schematic drawing of air ventilation cooling according to the preferred embodiment of the present invention. The second heat sink **30** accepts heat from the electronic element **15** of the second circuit board **10** and uses the first heat pipe **40** and the second heat pipe **45** to transmit the heat to the first heat sink **50** and the third heat sink **55** to increase the entire cooling surface area and the cooling performance. Then, the first air ventilation duct **60** and the second air ventilation duct **70** induce the heat to the first fan **80** and the second fan **90** for forced cooling. Therefore, the present invention requires only the first fan **80** and the second fan **90,** but is able to provide high cooling efficiencies with a low noise signature.

Although the present invention has been explained in relation to its preferred embodiment, it is to be understood that many other possible modifications and variations can be made without departing from the spirit and scope of the invention as hereinafter claimed.

## Claims

1. An electronic device comprising:
a first circuit board;
a first fan electrically connected to the first circuit board;
a second circuit board connected to the first circuit board;
a first heat sink connected to the second circuit board; and
a first air ventilation duct connected to the first fan, and the first heat sink.

2. The electronic device as claimed in claim 1, wherein the first air ventilation duct comprises a first vent, a second vent, and a duct body, the duct body connected with the first vent and the second vent, the second vent connected to the first fan, and the first vent connected to the first heat sink.

3. The electronic device as claimed in claim 2, wherein at least one part of the first heat sink is disposed in the first vent.

4. The electronic device as claimed in claim 1 further comprising a first heat pipe, and a second heat sink; wherein one end of the first heat pipe is fixed in the first heat sink, and another end of the first heat pipe is fixed in the second heat sink.

5. The electronic device as claimed in claim 4, wherein one side of the first heat sink has a first connection, and the duct body has a second connection corresponding to the first connection.

6. The electronic device as claimed in claim 5, wherein the first connection is a post, the second connection is a slit.

7. The electronic device as claimed in claim 1, wherein the second heat sink comprises a base and a plurality of cooling fins, the plurality of cooling fins are arranged in parallel and connected to the base.

8. The electronic device as claimed in claim 7 further comprising an electronic element, the electronic element disposed on the second circuit board, the base is disposed on the second circuit board and contacts the electronic element.

9. The electronic device as claimed in claim 1, wherein the second circuit board is a display card, and the first fan is a CPU fan.

10. The electronic device as claimed in claim 1, wherein the first fan is a system fan.
